# EUROPEAN PATENT APPLICATION

(11) **EP 4 465 538 A1**
(43) Date of publication of application: **20.11.2024**
(21) Application number: 23382470.5
(22) Date of filing: 19.05.2023
(51) Int. Cl.: H03M 3/00

(54) **DELTA-SIGMA SENSING DEVICE**

(71) Applicant: Universitat Autònoma de Barcelona, 08193 Bellaterra Barcelona (ES); Consejo Superior de Investigaciones Cientificas, 28006 Madrid (ES)
(72) Inventor: Margarit Taulé, Josep Maria, Barcelona (ES); Cuenca Michans, Javier, Barcelona (ES); Terés Terés, Lluís, Barcelona (ES); Serra Graells, Francisco, Barcelona (ES)
(74) Representative: Pons

(57) **Abstract**

A delta-sigma device that comprises transducers (2) and delta-sigma modulators (3) wherein the transducers (2) comprise: a sensing stage (100) that detect a property of the environment (106) and an interfacing stage (101); and the delta-sigma modulators (3) comprise: an input stage (113, 114), connected to the interfacing stages (101), for receiving an unfiltered intramodulator feedback signal (109) and a low-pass-filtered intramodulator feedback signal (110), and subtracting them from a sum of one or more of the input transduced signals (108) to obtain a delta error signal (111), a feedforward low-pass filtering stage (102); an analog-to-digital encoder (104), that converts the filtered delta error signal into a digital output signal dₒᵤₜ(t) (112), an unfiltered intramodulator feedback path, that converts dₒᵤₜ(t) (112) into the unfiltered intramodulator feedback signal (109), and a low-pass-filtered intramodulator feedback path, that converts dₒᵤₜ(t) (112) into the low-pass-filtered intramodulator feedback signal (110).

## Description

### OBJECT OF THE INVENTION

The object of the present invention is a delta-sigma sensing device with background signal attenuation and distributed encoding.

### BACKGROUND OF THE INVENTION

Sensor technologies play a critical role in various industries, including environmental monitoring, automotive, aerospace, medical, and consumer electronics. These sensors are designed to measure and monitor different physical (e.g., pressure, temperature, humidity) and chemical (e.g., analyte concentrations) parameters, providing essential data for a wide range of applications. To enable the sensors to communicate with other devices for performing further computation, the sensors are commonly "smartened" by incorporation of integrated circuits for processing the sensor signal and converting it into a digital format readable from external user devices.

Achieving high precision and accuracy in smart sensing devices is often hampered by factors such as drift and offset. Drift refers to a slow, continuous change in the output of a sensor over time, independent of the input signal of interest. This can be attributed to aging, contamination of the sensing surface, and other environmental factors such as thermal, mechanical or electrical stress. Offset, on the other hand, is a constant component in the sensor output signal, regardless of the input value. It is usually caused by manufacturing imperfections or other external influences. Inaccurate measurements may lead to incorrect decision-making, reduced system efficiency, and, in some cases, critical failures.

In practice, calibration of these two factors is frequently required for the sensing devices to perform within operational requirements. Calibration needs represent a key challenge to device autonomy together with energy consumption. A third aspect - miniaturization - adds to autonomy as crucial trait for enabling a ubiquitous usage of the devices. Recent advances to sensor technologies enable fabrication of physical and chemical sensors below the microscale. But, as the amplitude of the signals transduced decreases with size, downscaling accentuates the sensitivity to the aforementioned drift and offset effects.

Different strategies have been described in the state of the art to compensate for drift: A common one, subtracting a cancellation term from the sensor output during a calibration phase, is not effective for monitoring along extended periods of time as drift varies due to environmental determinants. Other popular techniques, like using a threshold to differentiate between signal changes and drift rely on the signal being larger than drift, which may not always be the case. Performing a differential measurement from a reference sensor requires electrical matching and drift similarity between the two, which might not be feasible due to intrinsic manufacturing variability.

Circuit methods proposed for removing or cancelling offset involve applying a bias at the device, reconfigured within a limited range during a separate calibration phase. The adoption of machine learning algorithms and artificial intelligence (Al) in sensor systems can also help to detect and compensate drift and offset. By analyzing historical sensor data and identifying patterns, these algorithms can predict and correct the resulting errors in real-time, leading to more accurate and reliable measurements. However, and due to their complexity, embedding Al models in a device generally translates into a substantial increase in its dimensions and energy budget.

In this scenario, electrochemical microsensors fabricated in semiconductor technologies offer advantages such as miniaturization, mass fabrication, and ease of integration with CMOS circuits for embedding signal processing as smart sensing devices.

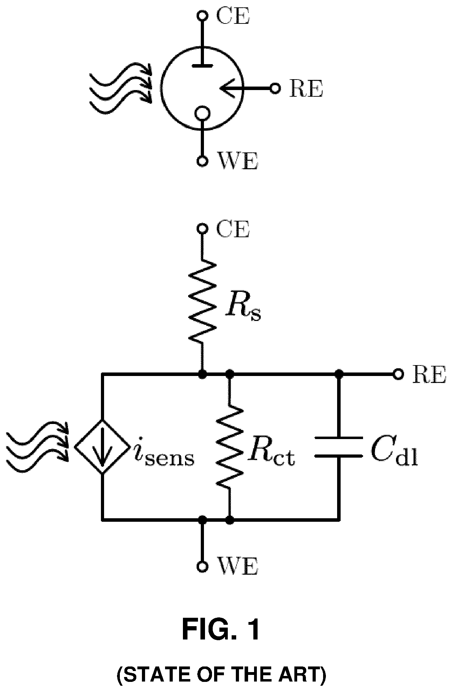

Indeed, the amperometric sensor family shown in figure 1 is particularly appealing since a simple three-microelectrode cell structure allows to evaluate redox reactions in solution at a target analyte potential (VRW) between reference (RE) and working (WE) electrodes. Under potentiostatic operation, that is ensuring a constant voltage at VRW and also null current through RE, the counter electrode (CE) supplies all the current needed for the electrochemical reaction at the surface of the WE. Thus, unwanted voltage drops of VRW at RE can be effectively avoided.

In this configuration, the electrode-electrolyte interface is usually modelled as the small-signal electrical circuit of figure 1, where iₛₑₙₛ is the CE-WE current change to be measured, while R_{ct}, C_{dl} and Rₛ stand for the charge transfer resistance, the double layer capacitance and the electrolyte solution resistance, respectively.

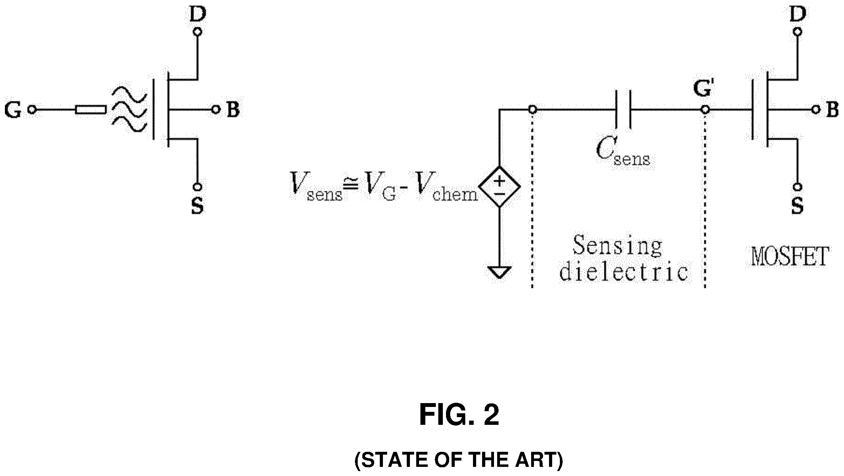

Figure 2 shows a field-effect transistor (FET) sensor easy to miniaturize and replicate as sensor array in semiconductor technologies. In standard CMOS technologies, the FET can be integrated as a metal-oxide-semiconductor transistor with the metal connection at the gate replaced by a liquid. The liquid contains the target analytes to be measured, which interact with the gate insulator functionalized as sensing surface. Changes in the analyte concentrations are transduced into a potential change at the gate insulator surface dependent upon the sensitivity to each analyte. These electrical variations in the gate potential can then be read out in the electrical domain by use of electronic circuits.

In the case of a FET electrochemical sensor fabricated in a standard CMOS technology, the FET can be modelled as the electrical circuit of figure 2, where Vₛₑₙₛ is the potential change to be measured due to a variation in the chemical contribuent V_{chem}, while Cₛₑₙₛ stand for the sensing capacitance due to the dielectric sensing membrane.

Despite the aforementioned advantages, the practical usage of electrochemical microsensors is limited by phenomena like fouling and parasitic currents or trapped charges at the sensing surface (e.g., drifting and offset components). Such phenomena introduce variability between sensors and can severely impair the dynamic range and accuracy of transient measurements.

Drift is particularly problematic for small signals and long-term measurements as it can be difficult to identify the signal amongst the shifting baseline. Together with offset components- and in the context of sensor readout, the sensor output can be driven outside of the analogue-to-digital converter input range and saturate. This also means an analogue-to-digital converter will need to cover a wide input range, which can increase quantization noise.

Classic solutions to integrate the potentiostatic-amperometric readout in CMOS technologies employ potentiostat circuits based on operational amplifiers that enforce a negative feedback loop of the CE current in order to control VRW. The resulting sensor current can then be translated into voltage and converted to the digital domain through pulse-width or pulse-density modulators.

Recent efforts have been directed to fusing both, the potentiostat and ADC functions, into a single circuit block using delta-sigma modulators. An interesting concept related with this scenario is what is known as sensor in the loop: reusing the sensor dynamics available shown in figure 1 as feedforward filtering stage for quantization noise shaping inside a delta-sigma modulator with either discrete- or continuous-time feedback. Apart from the obvious advantage of circuit power and area savings, the reuse of the sensor as continuous-time feedforward filter automatically adapts its anti-aliasing cut-off frequency to the sensor intrinsic bandwidth.

In the case of field-effect-transistor (FET) sensors, the common approach is to use the transistor as a voltage follower. More recent circuits read out the device in current mode, which facilitates direct filtering and the use of delta-sigma modulation schemes alike to the ones previously described for amperometric sensors.

On- and off-chip compensation methods have been proposed to overcome sensor offsets and drifts to some extent. However, none of the former approaches addresses, for instance, how to monitor in the long term under drift or offset interferents, which can have higher intensity than the signals of interest and may be influenced by evolving environmental factors. This is the case of commercial applications like environmental monitoring or wearable chemical sensing, in which the wide adoption of these analytical systems is still limited mainly due to sensor non-idealities, and due to the restricted deployability of these devices in terms of compactness and energy autonomy.

### DESCRIPTION OF THE INVENTION

The delta-sigma sensing device of the present invention has built-in adaptive pulse modulation encoding for delivering sensor biasing, analog-to-digital conversion, and attenuation of undesired background sensor signals (e.g., DC offset, drifts) lying out of the frequency band of interest.

The device comprises one or more transducers and one or more delta-sigma modulators. Firstly, each of the transducers comprises a sensing stage intended to detect a property of the environment such as temperature, humidity, analyte concentrations, and to convert it into an electrical input signal. Each transducer also comprises an interfacing stage, connected to the sensing stage, that receives the electrical input signal and feeds it as input transduced signal to one or more of the delta-sigma modulators.

Secondly, each of the delta-sigma modulators comprises an input stage, connected to the interfacing stage, for receiving an unfiltered intramodulator feedback signal and a low-pass-filtered intramodulator feedback signal, and subtracting them from a sum of one or more of the input transduced signals to obtain a delta error signal.

Following the input stage, each modulator comprises a feedforward low-pass filtering stage, that obtains a filtered delta error signal, and an analog-to-digital encoder, following the feedforward filtering stage, that converts the filtered delta error signal into a digital output signal dₒᵤₜ(t).

Between the analog-to-digital encoder and the input stage, the modulator comprises an unfiltered intramodulator feedback path, that converts dₒᵤₜ(t) into the unfiltered intramodulator feedback signal, and a low-pass-filtered intramodulator feedback path, between the analog-to-digital encoder and the input stage, that converts dₒᵤₜ(t) into the low-pass-filtered intramodulator feedback signal.

In front of the state of the art, the present invention offers:
(i) tunable compression of interfering frequency components to increase the dynamic range, the readout resolution, and the energy efficiency; and
(ii) distributed pulse modulation encoding, to increase the maximum overall encoder sampling rate and to effectively model dependencies between the input signals transduced by the sensors.

### DESCRIPTION OF THE DRAWINGS

To complement the description of the invention for a better understanding of its characteristics, and in accordance with a preferred example of practical embodiment thereof, a set of drawings is attached as an integral part of said description. The drawings represent, with illustrative and non-limiting character:
Figure 1.- Shows the small-signal electrical model of the electrode-electrolyte interfaces for a three-electrode electrochemical cell of the state of the art.
Figure 2.- Shows the electrical model of a FET electrochemical sensor of the state of the art fabricated in a standard CMOS technology.
Figure 3.- Shows a general schematic representation of a first example implementation of the device, in which each transducer is connected to a unique delta-sigma modulator.
Figures 4A and 4B.- Show a detailed schematic representation of a first example implementation of the device, in which each transducer is connected to a unique delta-sigma modulator.
Figure 5.- Shows a general schematic representation of a second example implementation of the device, in which one or more transducers are connected to one or more delta-sigma modulators.
Figure 6.- Shows a detailed schematic representation of a second example implementation of the device, in which one or more transducers are connected to one or more delta-sigma modulators.
Figure 7.- Shows a general schematic representation of a third example implementation of the device, in which some of the transducers are connected to more than one delta-sigma modulator, and wherein some of the outputs of the delta-sigma modulators are fed back to some of the other delta-sigma modulators that comprise the device.
Figure 8.- Shows a detailed schematic representation of a third example implementation of the device, in which some of the transducers are connected to more than one delta-sigma modulator, and wherein some of the outputs of the delta-sigma modulators are fed back to some of the other delta-sigma modulators that comprise the device.
Figures 9A and 9B.- Show a detailed schematic representation of the device implemented according to a first embodiment, in which a FET electrochemical transducer is connected to a delta-sigma modulator.
Figure 10.- Shows a detailed schematic representation of the device implemented according to a second embodiment, in which one or more FET electrochemical transducers are connected to one or more delta-sigma modulators.
Figure 11.- Shows a detailed schematic representation of the device implemented according to a third embodiment, in which a three-electrode cell - operating as a potentiostatic-amperometric transducer - is connected to a delta-sigma modulator.
Figure 12.- Shows a detailed schematic representation of the device implemented according to a fourth embodiment, in which one or more three-electrode cells, operating as a potentiostatic-amperometric transducers, are connected to one or more delta-sigma modulators.
Figure 13.- Shows the signal recovered after demodulating the transient response (bottom) of the first embodiment of the device to a prototypical increase in the analyte concentration causing a transition in the effective rate of Vₛₑₙₛ under constant, and substantial, drift rate (top).
Figure 14.- Shows the signal recovered after demodulating the transient response (bottom) of the third embodiment of the device to an Iₛₑₙₛ in line with a prototypical half voltammetry cycle with large resistive losses at the working electrode-electrolyte interface (top).

### PREFERRED EMBODIMENT OF THE INVENTION

It is described below, with the help of figures 1 to 14, a preferred embodiment of the delta-sigma device with background signal attenuation and distributed encoding, object of the present invention.

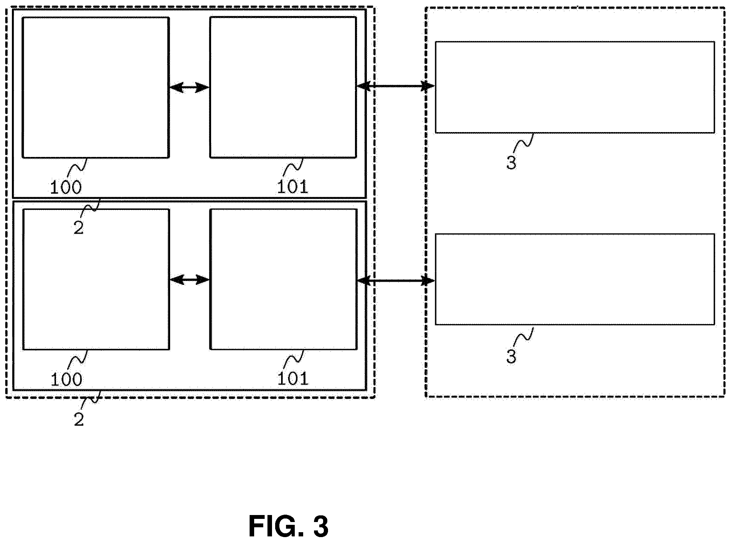

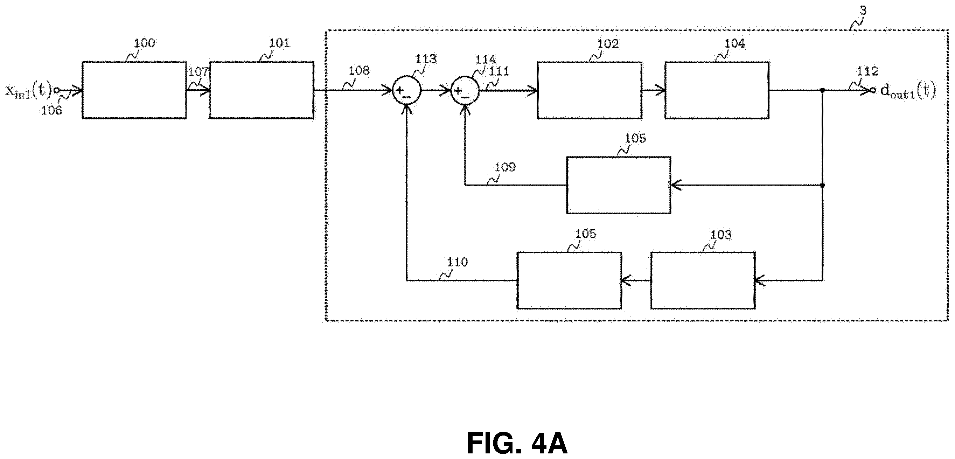

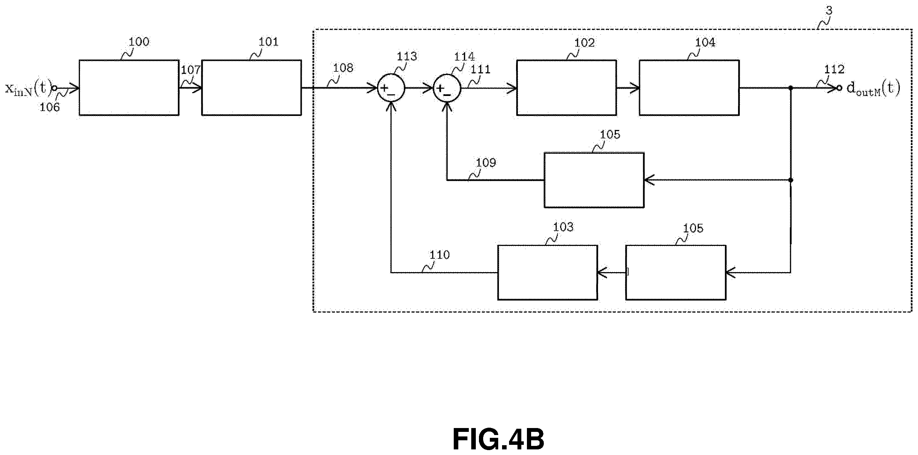

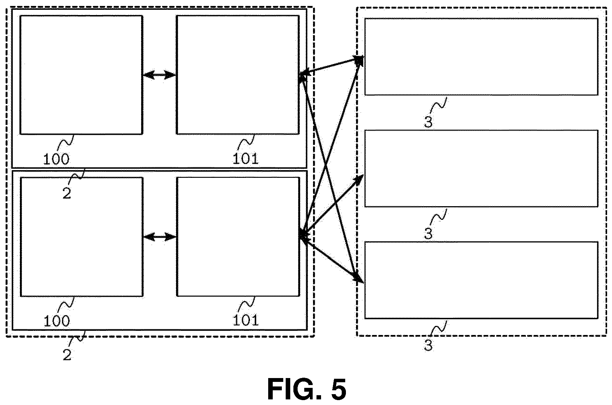

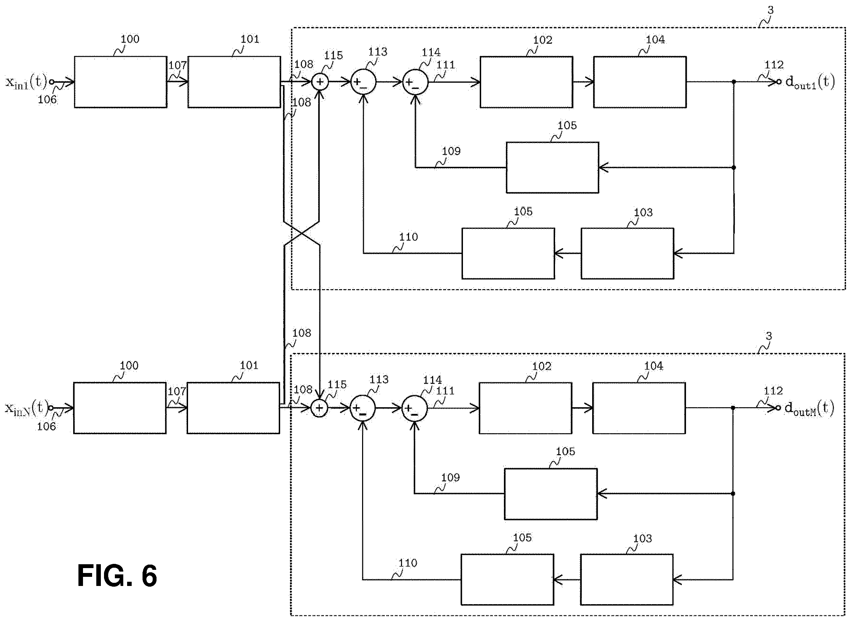

As presented in figures 3 and 5, the delta-sigma device comprises one or more transducers (2) and one or more delta-sigma modulators (3). As shown in detail in figures 4A, 4B and 6, each of the transducers (2) comprises a sensing stage (100) intended to detect a property of the environment Xᵢₙ₁(t) (106) and configured to convert it into an electrical input signal (107), and an interfacing stage (101), connected to the sensing stage (100), that receives the electrical input signal (107) and feeds it as input transduced signals (108) to one (figures 4A, 4B) or more (figure 6) of the delta-sigma modulators (3).

Moreover, each of the delta-sigma modulators (3) comprises, as shown in figures 4A, 4B and 6, an input stage (113, 114), connected to the interfacing stages (101), for receiving an unfiltered intramodulator feedback signal (109) and a low-pass-filtered intramodulator feedback signal (110), and subtracting them from a sum of one (figures 4A, 4B) or more (figure 6) input transduced signals (108) to obtain a delta error signal (111).

Following the input stage (113, 114), each modulator (3) comprises a feedforward low-pass filtering stage (102), configured to obtain a filtered delta error signal, an analog-to-digital encoder (104), following the feedforward filtering stage (102), that converts the filtered delta error signal into a digital output signal dₒᵤₜ(t) (112), an unfiltered intramodulator feedback path, between the analog-to-digital encoder (104) and the input stage (113, 114) that converts dₒᵤₜ(t) (112) into the unfiltered intramodulator feedback signal (109), and a low-pass-filtered intramodulator feedback path, between the analog-to-digital encoder (104) and the input stage (113, 114), that converts dₒᵤₜ(t) (112) into the low-pass-filtered intramodulator feedback signal (110).

In an aspect of the invention, shown in figures 3, 4A, and 4B, each transducer (2) is connected to a unique delta-sigma modulator (3).

In an aspect of the invention, presented in figures 5 and 6, each transducer (2) is connected to more than one delta-sigma modulators (3).

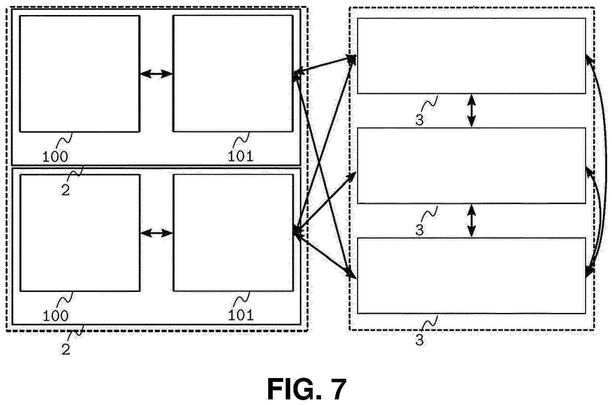

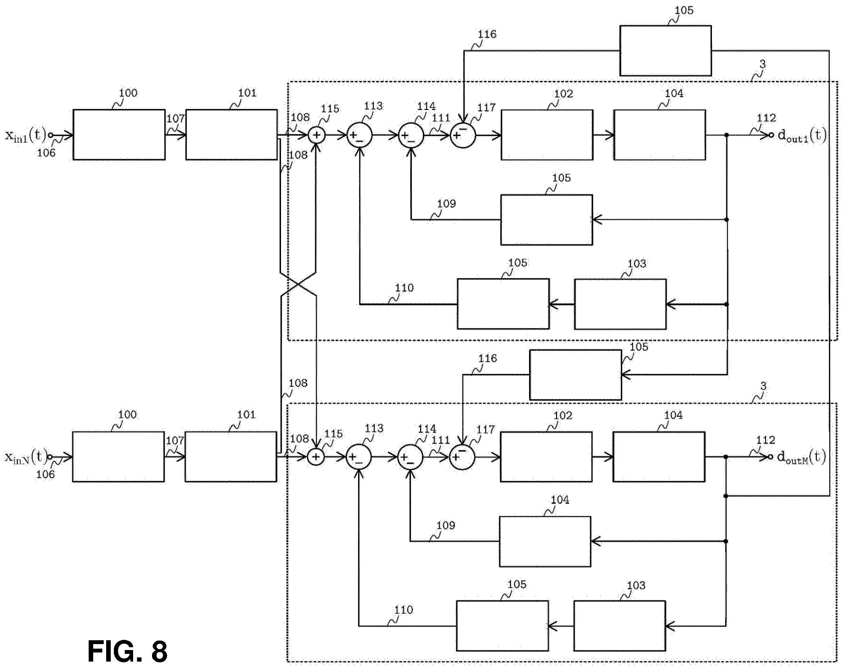

In an aspect of the invention, disclosed in figures 7 and 8, the device comprises one or more transducers (2) and two or more delta-sigma modulators (3). In this case, the device additionally comprises a plurality of unfiltered intermodulator feedback paths, connected to dₒᵤₜ(t) (112) of each delta-sigma modulator (3) and configured to convert dₒᵤₜ(t) into a plurality of unfiltered intermodulator feedback signals (116). What is more, the device additionally comprises a subtracting stage (117) before the feedforward low-pass filtering stage (102) that receives the unfiltered intermodulator feedback signals (116) of each unfiltered intermodulator feedback path.

In an aspect of the invention, the unfiltered intramodulator feedback paths and/or the unfiltered intermodulator feedback paths comprise a digital-to-analog converter stage (105).

In an aspect of the invention the low-pass-filtered intramodulator feedback paths comprise a feedback low-pass filtering stage (103) and a digital-to-analog converter stage (105).

The digital-to-analog-converter stage (105) can be placed before or after the low-pass filter, as shown in figure 4A and figure 4B.

In an aspect of the invention, the feedforward low-pass filtering stage (102) and the feedback low-pass filtering stages (103) comprise one or more leaky or non-leaky integrator stages, each integrator stage being configured to integrate a respective input signal.

Regarding this embodiment, the low-pass filtering stage can be implemented combining multiple feedback and feedforward loops in a backbone made of integrator stages cascaded in series. Negative feedback is used to connect integrator outputs to the inputs of same or previous integrator stages in order to regulate the gain and frequency response of the filter. Feedforward connects the output of each integrator stage to the input of next stages in order to compensate for phase and amplitude distortion introduced by the feedback mechanism.

What is more, a leaky integrator is a stage that receives an input signal and generates an output signal by integrating a leaked signal over time. The leaked signal is obtained based on a dampening factor applied to reduce the amplitude of the input signal. A non-leaky integrator is a stage that receives an input signal and generates an output signal by integrating the input signal without any leakage or dampening.

In an aspect of the invention, one or more of the leaky or non-leaky integrator stages of the feedforward filtering stage (102) comprises a circuit equivalent of the dynamic electrical response of the transducer (2).

A small-signal circuit equivalent is a simplified representation of the dynamic response of a device that describes its electrical behavior under small-signal excitation. The small-signal circuit equivalent consists of a set of linear circuit elements, such as resistors, capacitors, and controlled sources, that are connected to model the device.

In an aspect of the invention, the analog-to-digital encoder (104) of the delta-sigma modulators (3) comprises a one-bit synchronous or asynchronous quantizer.

In an aspect of the invention, the analog-to-digital encoder (104) of the delta-sigma modulators (3) comprises a one-bit asynchronous quantizer and a pulse generator that convert the filtered delta error signal into a digital, pulsing signal dₒᵤₜ(t) (113).

In an aspect of the invention, the analog-to-digital encoders (104) of the delta-sigma modulators (3) comprise a three-level asynchronous quantizer and a bipolar pulse generator that convert the filtered delta error signal into a digital, bipolar pulsing signal dₒᵤₜ(t) (113).

Regarding the previously described embodiments, a one-bit asynchronous quantizer is a stage that converts a continuous or discrete signal into a "0" or "1" binary signal using a thresholding operation. A one-bit synchronous quantizer converts a continuous or discrete signal into a binary signal using a thresholding operation and a sampling clock. It maps the input signal to either "0" or "1" at regular intervals determined by the clock frequency. A three-level asynchronous quantizer converts a continuous or discrete signal into three output levels using a thresholding operation. A three-level synchronous quantizer converts a continuous or discrete signal into three output levels using a thresholding operation and a clock determining regular sampling intervals.

Furthermore, a digital pulsing signal consists of a sequence of square wave electrical pulses, each occupying one of two discrete, binary levels of amplitude: "0" or "1". A bipolar pulsing signal consists of a sequence of square wave electrical pulses, each occupying one of three discrete levels of amplitude: positive, negative or zero.

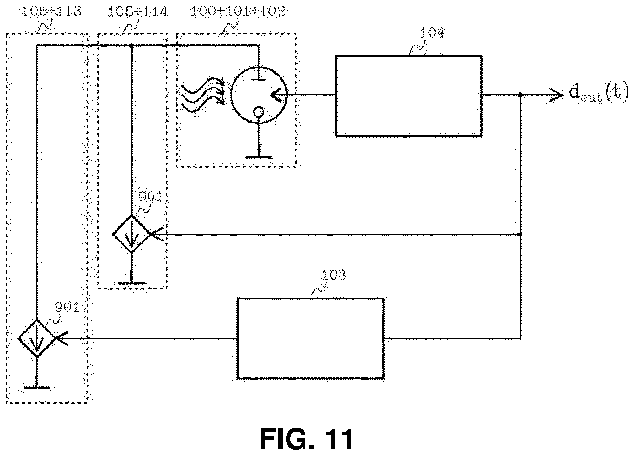

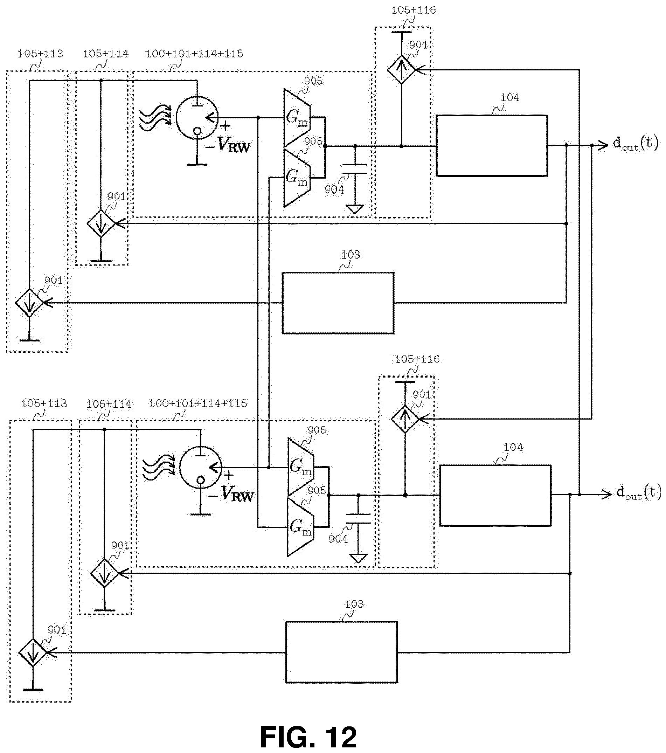

In an aspect of the invention, shown in figures 11 and 12, the transducers (2) are three-electrode cells operating as a potentiostatic-amperometric sensor, wherein the unfiltered intramodulator feedback signals (109), the low-pass-filtered intramodulator feedback signals (110), and the unfiltered intermodulator feedback signals (116) are current signals subtracted in current-mode to the delta error signal (111) of the delta sigma modulators of the device. Each three-electrode cell also comprises a sensing stage (100) and an interfacing stage (101).

In all feedback signals of figure 11, the digital-to-analog conversion is performed using current sources (901) controlled by dₒᵤₜ(t) or the output of the filtering stage (103). To allow programmable and miniaturized filtering of very low cut-off frequencies in a microchip, the low-pass filtering stage (103) of the filtered intramodulator feedback loop is implemented in the digital domain. To this end, an implementation of the low-pass filtering stage (103) can comprise a FIR (Finite Impulse Response) or IIR (Infinite Impulse Response) digital low-pass filter clocked at a frequency lower that the average quantization frequency of the pulse generated and higher than its cut-off frequency. In the case of asynchronous quantization, an implementation of the low-pass filtering stage can comprise an asynchronous counter stage, connected between dₒᵤₜ(t) and the digital low-pass filter, that synchronizes dₒᵤₜ(t) by accumulating its respective updates over a clock period of the digital filter. The sensed currents Iₛₑₙₛ are integrated by the sensor in the loop.

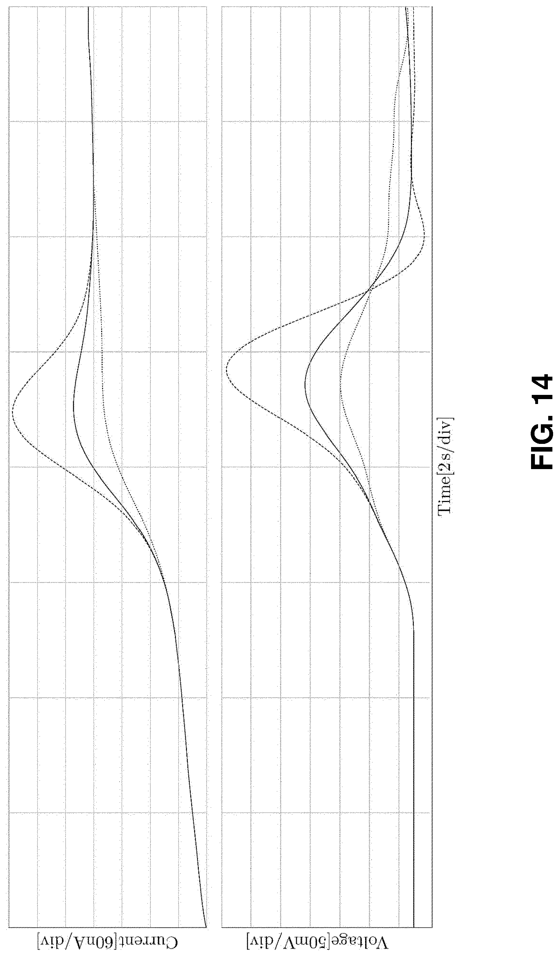

In figure 14, dashed, solid, and dotted lines correspond to voltammetries with oxidation peaks of decreasing magnitude, respectively. As seen in figure 14 (bottom), the device can be configured to compress the increasing sum of background and effective Iₛₑₙₛ signals into recovered bumps of decreasing magnitude. This facilitates discrimination of both the analyte concentration and electrode kinetics. It also extends the dynamic range available over time to read out the information of interest.

In Figure 12, the multiple Iₛₑₙₛ generated by the multiple transducers are integrated by each sensor in the loop, and the resulting integrated voltage signals are converted again to current by the transconductors (905) and summed up together in this current domain. The resulting summed current signal is integrated in the integrating capacitor (904) of a second integrator stage.

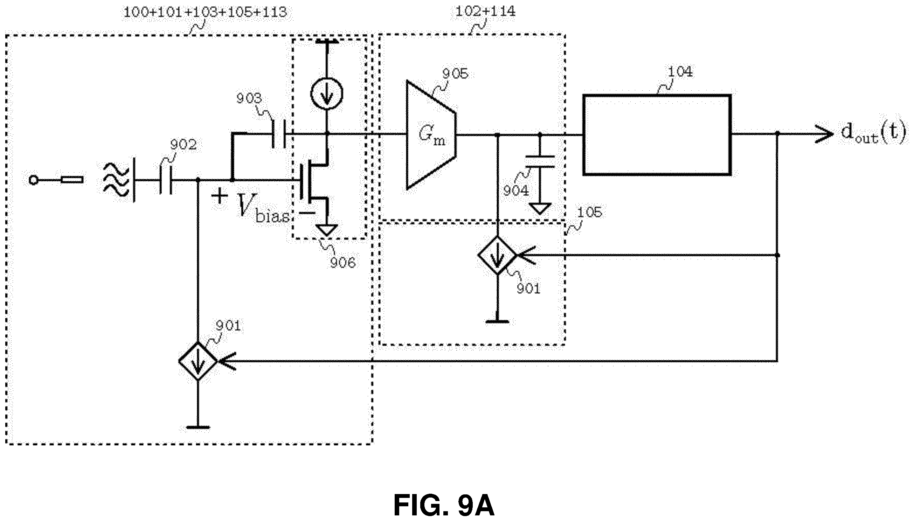

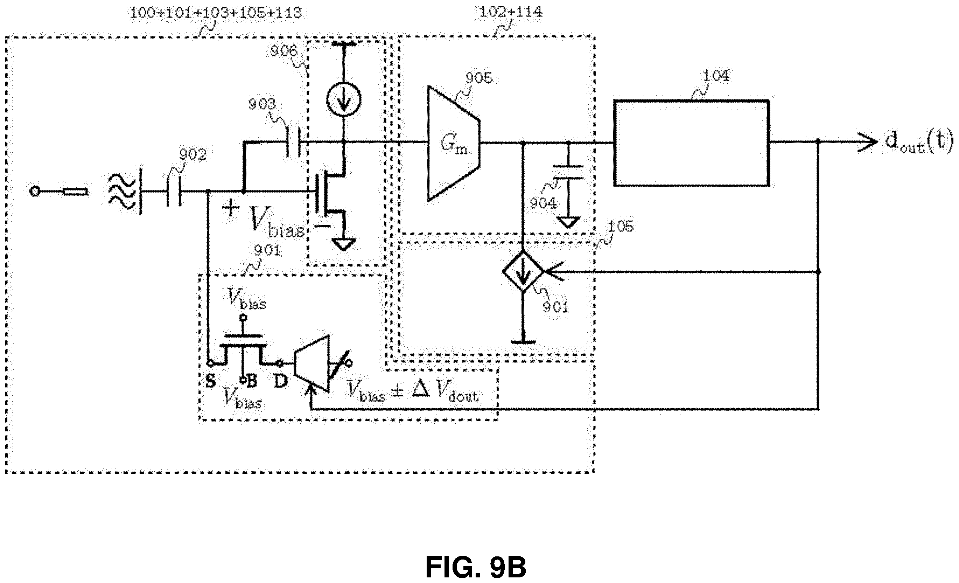

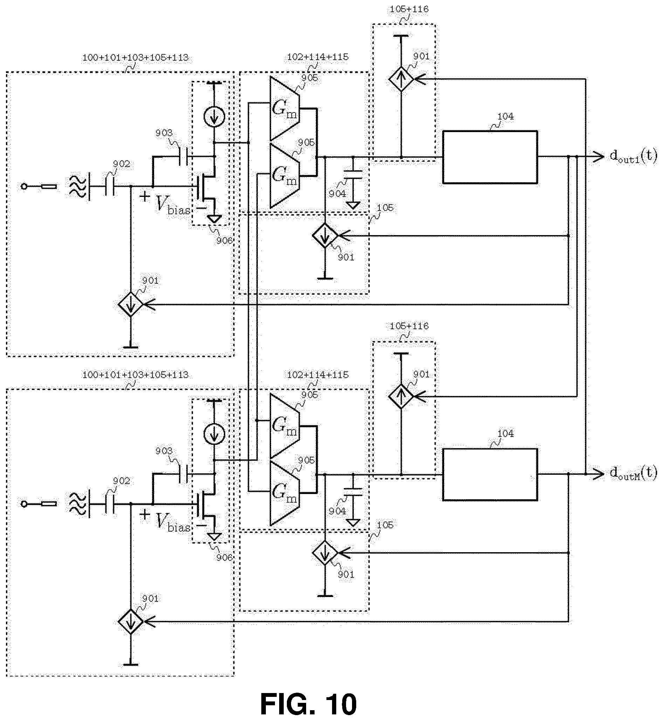

In an aspect of the invention, described in figures 9 and 10, the sensing stage (100) comprises a FET sensor, and the interfacing stage (101) performs capacitive amplification through the passivation capacitance of the FET sensor and a feedback capacitance, and wherein unfiltered intramodulator feedback signals, the low-pass-filtered intramodulator feedback signals, and the unfiltered intermodulator feedback signals are current signals subtracted in current-mode to the delta error signal of the delta sigma modulators that comprise the device.

In figures 9A, 9B, and 10, the digital-to-analog conversion of all feedback signals is performed using current sources (901) controlled by dₒᵤₜ(t). The capacitive amplification is performed by an amplifier (in this case a minimalistic implementation (906) comprising a current source and the metal-oxide-semiconductor (MOS) transistor of the FET sensor), the dielectric capacitance of the sensing membrane (902), and a feedback capacitor (903). The output voltage of the capacitive amplifier is connected to a transconductor (905) that converts it to a transconductor output current. After current-mode subtraction of the unfiltered intramodulator signal and, optionally, the unfiltered intermodulator signal, the transconductor output current is integrated in the integrating capacitor (904) of a single-stage integrator.

To allow the configuration of very-low cut-off frequencies in a microchip, and to minimize the leakage at the gate of the MOS transistor, the controlled current source of the low-pass-filtered intramodulator feedback path can be implemented as depicted in figure 9B: using an ultra-low leakage MOS transistor operating with a selectable drain-source voltage via an e.g. multiplexer stage. The transistor can be biased to have a null drain-source voltage when the output of dₒᵤₜ(t) is zero. It can also be biased to a null source-bulk voltages, which cause null conduction through the MOS transistor channel and the diffusion diodes, respectively, from the capacitive amplifier. While a non-zero dₒᵤₜ(t) selects a non-zero drain-source voltage, this voltage (i.e. ±ΔV_{dout}) can be set in practice to be also very low and proportional to dₒᵤₜ(t).

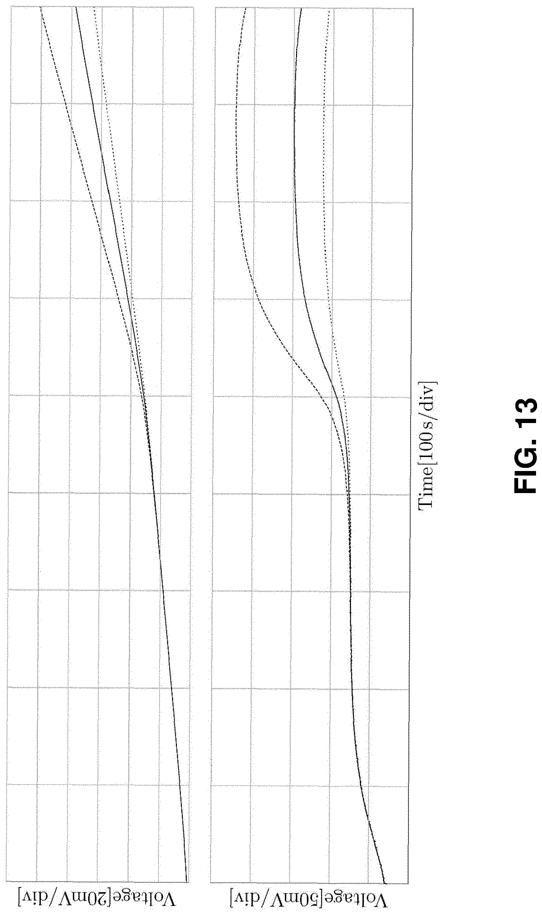

In figure 13, the solid line corresponds to an increase in the analyte concentration causing a similar effective Vₛₑₙₛ rate than the drift Vₛₑₙₛ rate; the dotted line corresponds to an increase in the analyte concentration causing an effective Vₛₑₙₛ rate of approximately half the drift Vₛₑₙₛ rate; the dashed line corresponds to an increase in the analyte concentration causing an effective Vₛₑₙₛ rate of approximately double the drift Vₛₑₙₛ rate. As seen in figure 13 (bottom), the device of figures 9A and 9B can be configured to compress the increasing sum of drift and effective Vₛₑₙₛ signals into recovered bumps of amplitude proportional to the added rates. This facilitates discrimination of the effective Vₛₑₙₛ signal to detect in front of the drift, and identification of the chemical reactive rising the concentration of the analyte of interest. It also extends the dynamic range available over time in front of the sensor drift.

## Claims

1. A delta-sigma device **characterized in that** it comprises one or more transducers (2) and one or more delta-sigma modulators (3) wherein each of the transducers (2) comprises:
- a sensing stage (100) intended to detect a property of the environment Xᵢₙ(t) (106) and configured to convert it into an electrical input signal (107), and
- an interfacing stage (101), connected to the sensing stage (100), that receives the electrical input signal (107) and feeds it as input transduced signals (108) to one or more of the delta-sigma modulators (3),
and wherein each of the delta-sigma modulators (3) comprises:
- an input stage (113, 114), connected to the interfacing stages (101), for receiving an unfiltered intramodulator feedback signal (109) and a low-pass-filtered intramodulator feedback signal (110), and subtracting them from a sum of one or more of the input transduced signals (108) to obtain a delta error signal (111),
- a feedforward low-pass filtering stage (102), following the input stage (113, 114), configured to obtain a filtered delta error signal;
- an analog-to-digital encoder (104), following the feedforward filtering stage (102), that converts the filtered delta error signal into a digital output signal dₒᵤₜ(t) (112),
- an unfiltered intramodulator feedback path, that comprises a digital-to-analog converter stage (105) between the analog-to-digital encoder (104) and the input stage (113, 114), that converts dₒᵤₜ(t) (112) into the unfiltered intramodulator feedback signal (109), and
- a low-pass-filtered intramodulator feedback path that comprises a feedback low-pass filtering stage (103) and a digital-to-analog converter stage (105), between the analog-to-digital encoder (104) and the input stage (113, 114), that convert dₒᵤₜ(t) (112) into the low-pass-filtered intramodulator feedback signal (110).

2. The device of claim 1, wherein each transducer (2) is connected to a single delta-sigma modulator (3).

3. The device of claim 1, wherein each transducer (2) is connected to more than one delta-sigma modulator (3).

4. The device of claim 1, wherein it comprises one or more transducers (2) and two or more delta-sigma modulators (3), and wherein the device additionally comprises a plurality of unfiltered intermodulator feedback paths that comprise a digital-to-analog converter stage (105), connected to dₒᵤₜ(t) (112) of each delta-sigma modulator (3) and configured to convert dₒᵤₜ(t) into a plurality of unfiltered intermodulator feedback signals (116), and wherein the device additionally comprises a subtracting stage (117) before the feedforward low-pass filtering stage (102) that receives the unfiltered intermodulator feedback signals (116) of each unfiltered intermodulator feedback path.

5. The device of claims 1, wherein the feedforward low-pass filtering stage (102) or the feedback low-pass filtering stages (103) comprise one or more leaky or non-leaky integrator stages, each integrator stage being configured to integrate a respective input signal.

6. The device of claim 5, wherein one or more of the leaky or non-leaky integrator stages of the feedforward filtering stage (102) comprises a circuit equivalent of the dynamic electrical response of the transducer (2).

7. The device of claim 1, wherein the analog-to-digital encoder (104) of the delta-sigma modulators (3) comprises a one-bit synchronous or asynchronous quantizer.

8. The device of claim 1, wherein the analog-to-digital encoder (104) of the delta-sigma modulators (3) comprises a one-bit asynchronous quantizer and a pulse generator that convert the filtered delta error signal into a digital, pulsing signal dₒᵤₜ(t) (113) with a quantization frequency.

9. The device of claim 8, wherein the low-pass filtering stage (103) additionally comprises a FIR (Finite Impulse Response) or IIR (Infinite Impulse Response) digital low-pass filter clocked at a frequency lower that the average of the quantization frequency and higher than its cut-off frequency.

10. The device of claim 9, wherein the low-pass filtering stage (103) additionally comprises an asynchronous counter stage, connected between dₒᵤₜ(t) and the digital low-pass filter, for synchronizing dₒᵤₜ(t).

11. The device of claim 1, wherein the analog-to-digital encoders (104) of the delta-sigma modulators (3) comprise a three-level asynchronous quantizer and a bipolar pulse generator that convert the filtered delta error signal into a digital, bipolar pulsing signal dₒᵤₜ(t) (113).

12. The device of claim 1, wherein the transducers (2) are three-electrode cells operating as a potentiostatic-amperometric sensor, and wherein the unfiltered intramodulator feedback signals, the low-pass-filtered intramodulator feedback signals, and the unfiltered intermodulator feedback signals are current signals subtracted in current-mode to the delta error signal (111).

13. The device of claim 12, wherein the digital-to-analog converter stage (105) comprises current sources (901) controlled by dₒᵤₜ(t) or the output of the filtering stage (103).

14. The device of claim 13, wherein the controlled current sources (901) comprise an ultra-low leakage MOS transistor operating with a selectable drain-source voltage.

15. The device of claim 1, wherein the sensing stage (100) comprises a FET sensor, and the interfacing stage (101) performs capacitive amplification through the passivation capacitance of the FET sensor and a feedback capacitance, and wherein unfiltered intramodulator feedback signals (109), the low-pass-filtered intramodulator feedback signals (110), and the unfiltered intermodulator feedback signals (116) are current signals subtracted in current-mode to the delta error signal (111).
